(19) Europäisches Patentamt
European Patent Office
Office européen des brevets

(11) **EP 4 486 100 A1**

(12) **EUROPEAN PATENT APPLICATION**

(43) Date of publication:
01.01.2025 Bulletin 2025/01

(21) Application number: 23306069.8

(22) Date of filing: 29.06.2023

(51) International Patent Classification (IPC):
*H10N 60/01* (2023.01)    *G06N 10/40* (2022.01)
*H10N 60/12* (2023.01)    *H10N 69/00* (2023.01)

(52) Cooperative Patent Classification (CPC):
**H10N 60/12; G06N 10/00; G06N 10/40;**
**H10N 60/0912; H10N 69/00**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Centre National de la Recherche Scientifique**
**75016 Paris (FR)**

(72) Inventors:
• **Cano, Andrés**
Grenoble (FR)
• **Donaire, Manuel**
Griñón (ES)

(74) Representative: **IPAZ**
**Bâtiment Platon**
**Parc Les Algorithmes**
**91190 Saint-Aubin (FR)**

(54) **SUPERCONDUCTING QUBIT DEVICES AND METHODS FOR FABRICATING SUPERCONDUCTING QUBIT DEVICES**

(57) According to an aspect, the present description relates to a superconducting qubit (200) comprising at least one capacitor (202) and at least one Josephson junction (204) electrically coupled in parallel to the capacitor (202). The capacitor (202) comprises a first ferroelectric material (206), a first electrode (208) of a first superconducting material, and a second electrode (210) of a second superconducting material. The first electrode (208) and the second electrode (210) are in electric contact with the first ferroelectric material (206). The Josephson junction (204) comprises a first region (212) of a third superconducting material and a second region (214) of a fourth superconducting material coupled to said first region (212) by a third region (216) of a fifth material.

FIG.2

## Description

### Technical field

The present description relates to superconducting qubit devices. The present description also relates to methods for fabricating superconducting qubit devices.

### Background of the Invention

A quantum processor is a device that is configured to process input data by using quantum states of physical systems in order to implement an algorithm on said input data and generate output data. For example, algorithms may comprise a sequence of quantum operations that are implemented using quantum mechanical systems configured to store a quantum information. Conventionally, quantum information may be stored using quantum bits, referred to as "qubits," which are typically quantum mechanical systems exhibiting two or more states, called "basis states". The states of a qubit can be used to encode quantum information. For example, a qubit may be realized as a quantum system that has a ground state and an excited state, and these two basic states may be used to denote quantum bit values of 0 and 1. The quantum nature of a qubit is related to its ability to exist in a coherent superposition of basis states, and for the state of the qubit to have a phase. A qubit will retain this ability to exist as a coherent superposition of basis states when the qubit is sufficiently isolated from sources of decoherence [Ref. 1].

A quantum property that a qubit must exhibit is the ability to store energy in discrete values and an uneven spacing between the different energy levels. The uneven spacing of energy levels of a qubit is known as anharmonicity.

A small electric circuit built using superconducting wires may become a qubit with discrete energy levels. For some materials the conduction electrons are bounded together by interactions forming Cooper pairs. Unlike individual electrons, multiple Cooper pairs may be in the same quantum state, giving rise to the phenomenon of superconductivity [Ref. 2].

In order to keep its superconducting properties, preventing the superconducting circuit from warming up is desired. Two types of elements in a superconducting circuit do not produce heat: capacitors and inductors. A capacitor comprises two metallic elements that store electric charge, while an inductor comprises a wire that stores a magnetic field when a current passes through. A capacitor-inductance circuit with superconducting wires may have discrete energy levels. However, such energy levels are evenly spaced, making it impossible to isolate only two specific states. The solution to the problem of uneven spacing is provided by a Josephson junction.

A Josephson junction comprises two superconducting materials separated by a barrier of a different material [Ref. 2]. The supercurrent going through the barrier is reduced but not completely stopped because of a "tunnel effect". Cooper pairs can tunnel through the barrier and couple the superconducting wave functions on either side of the barrier. By replacing the inductor of the circuit with a Josephson junction, the energy levels of the superconducting circuit become unevenly spaced. Thanks to this anharmonicity, the qubit can be made to operate with two basic states, a ground state and first excited state.

Among different physical implementations, superconducting qubits are nowadays considered as one of the most promising technologies for quantum processing. In particular, superconducting qubits have been used to demonstrate quantum supremacy, *i.e.*, the possibility of solving problems that no classical computer can solve in any feasible amount of time.

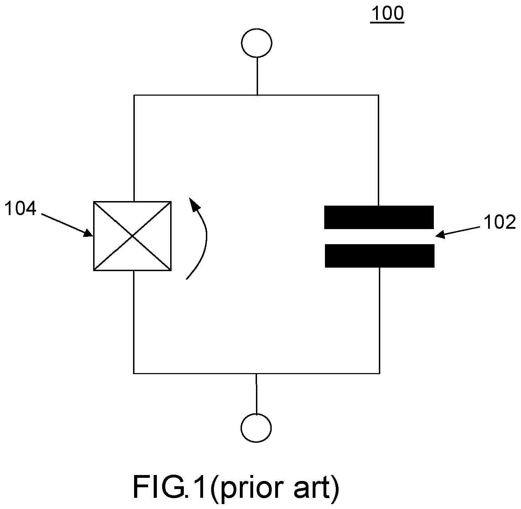

Fig. 1 shows a diagram of a superconducting qubit 100 including a capacitor 102 and a Josephson junction 104. Such superconducting qubit 100 generally includes one or more Josephson junctions 104 connected to one or more other circuit elements. The circuit elements may be one or more capacitors 102 (for charge qubits, see Fig. 1) or superconducting loops (for flux qubits). The charging energy $E_C$ of such superconducting qubit is defined as $(2e)^2/(2C)$, where $e$ is the electron charge and $C$ is the capacitance of the capacitor. The Josephson energy, $E_J$, is a characteristic parameter of the Josephson junction 104 defined as $E_J = I_c h/(4\pi e)$, where $I_c$ is the maximum supercurrent that the Josephson junction can support and $h$ is the Planck constant.

When used in a quantum processor, the qubit 100 may be connected to a gate capacitor so that it can receive external signals. However, a small change or noise in the gate charge can lead to changes in the qubit energy levels (that is, to changes in the relative energy between the ground state and the first excited state of the superconducting circuit). This issue is addressed in superconducting qubits of the prior art by increasing the size of the capacitor and thereby the capacitance $C$ of the qubit (and thus, decreasing the charging energy $E_C$), because the energy level differences then become less sensitive to the gate charge. However, the energy levels of the circuit then rapidly become evenly separated. A problem of such superconducting qubits is thus to achieve charge-noise insensitiveness retaining sufficient anharmonicity to ensure that the ground state and the first excited state of the device are effectively decoupled from the other states.

A qubit with a capacitor of a size such that the charging energy is significantly lower than the Josephson energy is known as a Transmon [Ref. 3]. Transmons, qubits with a name coming from the abbreviation of "transmission line shunted plasma oscillation qubits", have proven to be highly effective, and they are used in many applications associated with quantum systems, such as quantum processors, quantum amplifiers, quantum sensors, etc.

However, there are still some technological challenges regarding superconducting qubits such as Transmons. The large capacitance of the Transmon has the disadvantage of making the spacing of energy levels uniform [Ref. 4]. In addition, Transmons are large in size compared to other quantum systems, so their interaction with the environment is difficult to control and its scalability (or miniaturization) is limited.

Thus, there is a need for a superconducting qubit of smaller size with improved charge-noise insensitiveness and anharmonicity than in the prior art.

SUMMARY

In what follows, the term "comprise" is synonym of (means the same as) "include" and "contain", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present description relates to a superconducting qubit comprising:

at least one capacitor comprising a first ferroelectric material, a first electrode of a first superconducting material, and a second electrode of a second superconducting material, wherein the first electrode and the second electrode are in electric contact with the first ferroelectric material; and

at least one Josephson junction electrically coupled in parallel to the capacitor wherein said Josephson junction comprises a first region of a third superconducting material and a second region of a fourth superconducting material coupled to said first region by a third region of a fifth material.

The applicants have shown that the superconducting qubit of the first aspect reaches charge-noise insensitivity and high anharmonicity regimes. The desired operation regimes can be reached with reduced critical currents at the Josephson junction, relative to the prior art. In addition, because of the large dielectric constants of the ferroelectric materials, the size of the capacitor may be reduced in several orders of magnitude, facilitating the miniaturization of the superconducting qubit.

According to one or further embodiments, the first ferroelectric material may be strontium titanate doped with calcium $Sr_{1-x}Ca_xTiO_3$, wherein x is 0, 1, or a value between 0 and 1. A superconducting qubit with $Sr_{1-x}Ca_xTiO_3$ as ferroelectric material in the capacitor can be configured to operate in the optimal conditions of anharmonicity and charge-noise insensitivity.

According to one or further embodiments, said fifth material of the third region may be a superconducting material with a critical temperature that is different from critical temperatures of the third and fourth superconducting materials. A fifth material with a critical temperature different from the critical temperature of the third and fourth superconducting materials determines the supercurrent that can travel through the Josephson junction.

According to one or further embodiments, said fifth material of the third region may be a second ferroelectric material. The second ferroelectric material may be $Sr_{1-x}Ca_xTiO_3$, wherein x is 0, 1, or a value between 0 and 1. Using a ferroelectric material in the third region of the Josephson junction simplifies the manufacturing of the superconducting qubit.

According to one or further embodiments, said first superconducting material may be niobium nitride (NbN). The superconducting material niobium nitride may be deposited in thin layers during fabrication, contributing to the miniaturization of the superconducting qubit.

According to one or further embodiments, at least one of the first, second, third and fourth superconducting materials is NbN.

According to one or further embodiments, all of the first, second, third and fourth superconducting materials are NbN.

According to one or further embodiments, said superconducting qubit may be configured to operate in the regime of incipient ferroelectricity. The regime of incipient ferroelectricity provides enhanced anharmonicity for the superconducting qubit.

According to one or further embodiments, said superconducting qubit may be configured to operate in the regime of ferroelectricity. The regime of ferroelectricity provides an optimal combination of charge-noise insensitivity and anharmonicity for the superconducting qubit.

According to one or further embodiments, a total energy of said superconducting qubit under operation comprises a quadratic term function of a normalized charge $\hat{n}$ and a non-quadratic term function of the normalized charge $\hat{n}$, and wherein an absolute value of a ratio between a coefficient of the quadratic term and a coefficient of the non-quadratic term is less than or equal to 10. With the absolute value of the ratio between the coefficient of the quadratic term and the coefficient of the non-quadratic term being less than or equal to 10, the superconducting qubit operates towards the point of transition between the regime of incipient ferroelectricity and the regime of ferroelectricity. Under such conditions, the anharmonicity, the energy level spacing, increases.

According to one or further embodiments, a charging energy $E_C$ of said superconducting qubit under operation is less or equal than an energy of the Josephson junction $E_J$. With the charging energy $E_C$ less than or equal to the energy of the Josephson junction $E_J$, the charge dispersion of the superconducting qubit becomes negligible.

According to a second aspect, the present description relates to a method of manufacturing a superconducting qubit according to any embodiment of the first aspect. The method comprises:

depositing, adjacent to a substrate, a layer of a first ferroelectric material, and at least one of a first layer of a first superconducting material and a second layer of a second superconducting material;
forming two electrodes by patterning at least one of the layer of the first ferroelectric material and the at least one of the first layer of a first superconducting material and the second layer of a second superconducting material;
forming at least one capacitor by electrically coupling the electrodes with the layer of the first ferroelectric material;
forming, adjacent to the electrodes, a first region of a third superconducting material and a second region of a fourth superconducting material;
forming at least one Josephson junction by coupling the first region and the second region by a third region of a fifth material; and
electrically coupling each of the first region and the second region to different electrode.

The method of manufacturing a superconducting qubit of the second aspect results in superconducting qubits with small size and high reproducibility. In addition, with such method of manufacturing the superconducting qubit, high quality interfaces among the different materials can be achieved, and thus, the strong anharmonicity of the superconducting qubit can be achieved and maintained during operation.

According to one or further embodiments, forming said first region and second region comprises patterning the layer of the first superconducting material.

According to one or further embodiments, forming said two electrodes comprises patterning using contact lithography.

According to one or further embodiments, forming said first region and second region comprises depositing said first region and second region by double angle evaporation.

According to one or further embodiments, forming said first region second region comprises patterning using electron-beam lithography.

According to one or further embodiments, said layer of the first ferroelectric material is deposited between two layers of the first superconducting material.

BRIEF DESCRIPTION OF THE DRAWINGS

Other advantages and features of the invention will become apparent on reading the description, which is illustrated by the following figures:

FIG. 1 (already described) illustrates a charge superconducting qubit according to the prior art.
FIG. 2 illustrates an example of a superconducting qubit according to the present description.
FIG. 3 illustrates charge-voltage relations for dielectrics and ferroelectric materials in an example of a superconducting qubit according to the present description.
FIG. 4 shows low-lying energy levels of embodiments in the incipient ferroelectric regime as a function of the charge noise in an example of a superconducting qubit according to the present description.
FIG. 5 shows parameters to quantify energy intervals of embodiments in the incipient ferroelectric regime in an example of a superconducting qubit according to the present description.
FIG. 6 shows a normalized dispersion factor for the superconducting qubit with a ferroelectric capacitor in an example of a superconducting qubit according to the present description.
FIG. 7 shows low-lying energy levels of embodiments in the ferroelectric regime as a function of the charge noise in an example of a superconducting qubit according to the present description.
FIG. 8 shows parameters to quantify energy intervals of embodiments in the ferroelectric regime in an example of a superconducting qubit according to the present description.
FIG. 9 shows logarithms of parameters to quantify energy intervals in the ferroelectric regime in an example of a superconducting qubit according to the present description.
FIG. 10 shows a flowchart of an example of a method to manufacture a superconducting qubit according to the present description.

FIGS. 11-14 illustrate examples of methods of fabrication superconducting qubits according to embodiments of the present description.

DETAILED DESCRIPTION

In the detailed description which follows, only some embodiments are described in detail in order to ensure clarity of the description, but these examples are not intended to limit the general scope of the principles that emerge from the present description.

The various embodiments and aspects described in the present description may be combined or simplified in multiple ways. In particular, the steps of the various methods may be repeated, reversed, or performed in parallel, unless otherwise specified.

When, in the present description, reference is made to calculating or processing steps for the implementation in particular of method steps, it is understood that each calculating or processing step may be implemented by software, hardware, firmware, microcode or any appropriate combination of these technologies. When software is used, each calculating or processing step may be implemented by computer program instructions or software code. These instructions may be stored in or transmitted to a storage medium that is readable by a computer (or computing unit) and/or be executed by a computer (or computing unit) in order to implement these calculating or processing steps.

In the figures, identical elements are indicated by the same references.

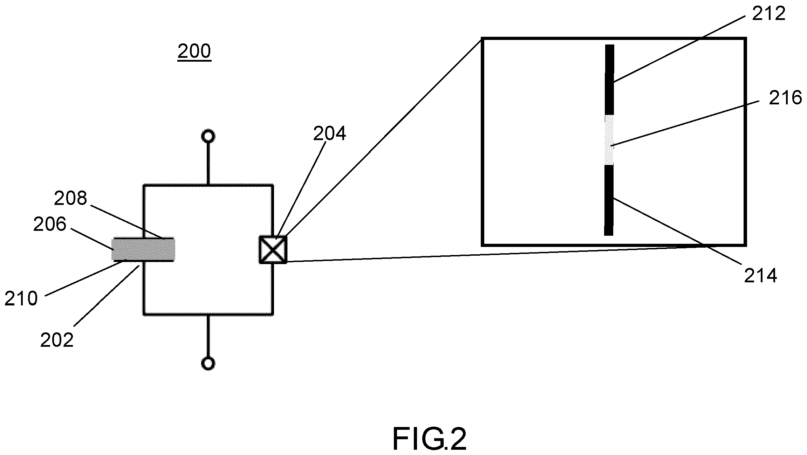

Fig. 2 represents a schematic view of a superconducting qubit 200, according to one or more embodiments. The superconducting qubit 200 includes one or more capacitor(s) 202 and one or more Josephson junction(s) 204. In Fig. 2, only one capacitor and one Josephson junction are shown. The Josephson junction(s) 204 is (are) electrically coupled in parallel with the capacitor(s) 202.

The capacitor 202 includes a first ferroelectric material 206, a first electrode 208 of a first superconducting material and a second electrode 210 of a second superconducting material. Both the first electrode 208 and the second electrode 210 are in electric contact with the first ferroelectric material 206.

The Josephson junction 204 includes a first region 212 of a third superconducting material and second region 214 of a fourth superconducting material. The second region 214 is coupled to the first region 212 by a third region 216 of a fifth material.

In some embodiments, at least one of the first, second, third and fourth superconducting materials is NbN. In a preferred embodiment of the present invention, all of the first, second, third and fourth superconducting materials are NbN. Non-limiting examples of superconducting materials include aluminum (Al), Niobium (Nb), tantalum (Ta), niobium nitride (NbN), and titanium nitride (TiN).

In some embodiments, the fifth material of the third region 215 of the Josephson junction 204 may be a second ferroelectric material. In other embodiments, the first ferroelectric material 206 and the second ferroelectric material are the same material. The first ferroelectric material 206 and/or the second ferroelectric material may be strontium titanate doped with calcium $Sr_{1-x}Ca_xTiO_3$, wherein x is 0, 1, or a value between 0 and 1. Other ferroelectric materials may be used, for example, strontium titanate ($SrTiO_3$), potassium tantalate ($KTaO_3$), barium titanate ($BaTiO_3$) and zirconium doped hafmium oxide ($Zr-HfO_2$), among others. In a preferred embodiment, both the first and the second ferroelectric materials are $Sr_{1-x}Ca_xTiO_3$ with $x = 0.0054$.

The superconducting qubit 200 including the capacitor 202 with a first ferroelectric material 206 may be operated in two different regimes, the incipient ferroelectricity regime and the ferroelectricity regime. The regimes may be obtained by adjusting control parameters such as chemical composition, temperature or pressure of the first ferroelectric material 206. In one or more embodiments of the present invention, the superconducting qubit 200 includes at least one capacitor 202 with $Sr_{1-x}Ca_xTiO_3$ and may be configured to operate either in the incipient ferroelectricity regime or in the ferroelectricity regime. Furthermore, in some embodiments, the control parameters may be adjusted to transition from incipient ferroelectricity to ferroelectricity (and vice versa). For example, the incipient ferroelectricity regime may change to ferroelectricity (and vice versa) at a particular temperature known as the ferroelectric transition temperature. In another example, incipient ferroelectricity down to 0 K in $SrTiO_3$ can be turned into ferroelectricity at a given non-zero temperature by means of cation doping, $^{18}O$ isotope substitution, or strains. The possibility of having two different regimes in a ferroelectric material, adds more degrees of freedom to control the different quantum transitions of the superconducting qubit 200.

In addition, when a ferroelectric material is used in a capacitor 202, a high capacitance can be obtained in a small volume. This is because ferroelectric materials have a large dielectric response, *i.e.*, the ordinary response of dielectrics but with very high dielectric constants. For example, silicon has a relative permittivity $\varepsilon_r$ (*i.e.*, a dielectric constant $\varepsilon$ divided by the vacuum dielectric constant $\varepsilon_0$) of 12 while a ferroelectric material such as $SrTiO_3$ may have a relative permittivity of 300 at room temperature, and of 20000 at 4 K.

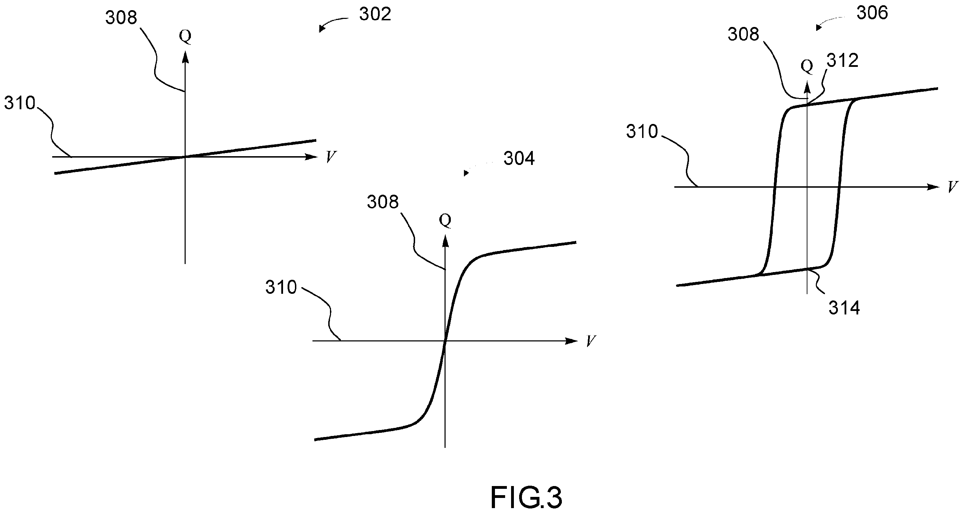

Fig. 3 illustrates a $Q$ - $V$ relation 302 for a linear dielectric material, a $Q$ - $V$ relation for a ferroelectric material working in the incipient ferroelectricity regime 304, and a $Q$ - $V$ relation for a ferroelectric material working in the ferroelectricity regime 306. In panels 302, 304 and 306 the vertical axis 308 indicates the charge $Q$ and the horizontal axis 310 indicates the voltage $V$. As seen in panels 304 and 306, the capacitor including the ferroelectric material may exhibit a $Q$ - $V$ relation that is non-linear. As panel 302 illustrates, the $Q$ - $V$ relation 302 of a linear dielectric material is linear and with a slope approaching the horizontal axis 310. At the same time, since the capacitance of a capacitor is given by the relation $C = Q/V$, Fig. 3 indicates that the capacitance of the capacitor with a ferroelectric material, either in the incipient ferroelectricity response 304 or in the ferroelectricity response 306, is larger than the capacitance of the dielectric material.

In the regime of ferroelectricity 306, the ferroelectric material exhibits hysteretic behavior. In addition, in the regime of ferroelectricity 306 an electric polarization appears in the absence of an external electric field, which is known as "spontaneous electric polarization". In the $Q$ - $V$ relation spontaneous electric polarization manifests itself as a positive charge 312 or negative charge 314 value when the voltage V is zero. The positive charge 312 and the negative charge 314 of the spontaneous electric polarization have an influence in the charging energy $E_C$ of the superconducting qubit, as it will be shown below.

The charging energy $E_C$ and the Josephson energy $E_J$ are related by the equation of total energy, known as the Hamiltonian of the superconducting qubit:

$$\hat{H} = \frac{a}{2}\left(\hat{n} - n_g\right)^2 + \frac{b}{4}\left(\hat{n} - n_g\right)^4 - E_J \cos \hat{\phi} \qquad \text{Eq. (1)}$$

where $\hat{n} = Q/(2e)$ is the normalized charge of the capacitor and $\hat{\phi}$ is the change in the phase of the Cooper pairs across the Josephson junction. The parameter $n_g$, the "charge offset" (also known as "charge noise"), is an offset in the normalized charge of the capacitor due to the environment of the circuit. For example, trapped charges in a substrate may induce fluctuating off-set charges in the superconducting qubit.

The first two terms on the right-hand side of Equation 1 are related to the capacitor and the third term to the Josephson junction. The non-linear response of the capacitor results from the parameter $a$ being close to zero. In addition, the parameter $a$ is positive in the regime of incipient ferroelectricity and negative in the regime of ferroelectricity. If the parameter $b$ is also small or negative, additional non-quadratic terms may need to be considered in Eq. (1). The quadratic term in Eq. (1) with the parameter $a$ close to zero and the non-quadratic term with the parameter $b$ embody the difference of the response of the superconducting qubit relative to the response of the Transmon.

The parameters $a$ and $b$ are material parameters and may be determined by the specific geometry of the capacitor 202 together with the Landau parameters $\alpha$ and $\beta$ of the ferroelectric material. The Landau parameters are coefficients in the Landau equation of free energy:

$$F = \frac{\alpha}{2}P^2 + \frac{\beta}{4}P^4 \qquad \text{Eq. (2)}$$

where P is the electric polarization. The parameter $\alpha$ is given by $\alpha = 1/[\varepsilon_0(\varepsilon_r^I - 1)]$, where $\varepsilon_r^I$ is the relative permittivity measured in the incipient ferroelectric regime. For the case of the ferroelectric material $SrTiO_3$, $\varepsilon_r^I = 9 \times 10^4/[42 \coth(42/T) - 38]$ and $\beta = 8 \times 10^9$ m$^6$N/C$^4$, where $T \leq 50$ is the temperature in Kelvins. For the ferroelectric material $Sr_{1-x}Ca_xTiO_3$ with $x = 0.0054$, $\varepsilon_r^I = 9 \times 10^4/[42 \coth(42/T) - 42.6046]$.

In some embodiments, the electrodes 208 and 210 of the capacitor 202 are made of two parallel plates. If the first ferroelectric material 206 is $Sr_{1-x}Ca_xTiO_3$, $x = 0.0054$, the parallel plates are separated 5 nm and each plate has an area of 100 nm$^2$, then the material parameters take the following values $b = 2.6 \times 10^{-3}$ meV and $a = 3.7 \times 10^{-3}$ meV, 0 meV and -24 $\times 10^{-3}$ meV at T = 17.5 K, 17 K, and 1 K respectively.

In one or more embodiments, the electrodes 208 and 210 of the capacitor are made of two coplanar plates separated 10 nm, where each plate has an area pf $20 \times 10$ nm$^2$. If the first ferroelectric material 206 is $Sr_{1-x}Ca_xTiO_3$, $x = 0.0054$ with a thickness of 5 nm, the material parameters take the following values b = $5.3 \times 10^{-3}$ meV and $a = 7.4 \times 10^{-3}$ meV, 0 meV and -49 $\times 10^{-3}$ meV at T = 17.5 K, 17 K, and 1 K respectively.

In one or more embodiments, the electrodes 208 and 210 of the capacitor are made of two coplanar plates separated 2.5 nm, where each plate has an area pf $15 \times 1$ nm$^2$. If the first ferroelectric material 206 is $Sr_{1-x}Ca_xTiO_3$, $x = 0.0054$, the material parameters take the following values b = $0.6 \times 10^{-3}$ meV and $a = 1.4 \times 10^{-3}$ meV, 0 meV and -9.4 $\times 10^{-3}$ meV at T = 17.5 K, 17 K, and 1 K respectively.

The expressions $a/2$ and $b/4$ in Eq. (1) are respectively the coefficients of the quadratic and non-quadratic contributions to the total energy, that are functions of the normalized charge $\hat{n}$ and are related to the charging energy $E_C$. In the case of incipient ferroelectricity ($a > 0$), as shown for example in panel 304, the relation is given by:

$$E_C = a/2 + b/4 \qquad\qquad \text{Eq. (3)}$$

and in the case of ferroelectricity as shown for example in panel 304 ($a < 0$) the charging energy $E_C$ is given by:

$$E_C = a/2 + b/4 + b(1 + 3|n_0|/2)|n_0| \qquad\qquad \text{Eq. (4)}$$

where $n_0$ is a spontaneous charge offset $n_0 = \pm\sqrt{-a/b}$ associated with a positive charge (312, Fig. 3) and a negative charge (314, Fig. 3) of the spontaneous electric polarization. Eqs. (2) and (3) indicate that the spontaneous charge offset $n_0$ of the ferroelectricity regime results in a larger charging energy $E_C$.

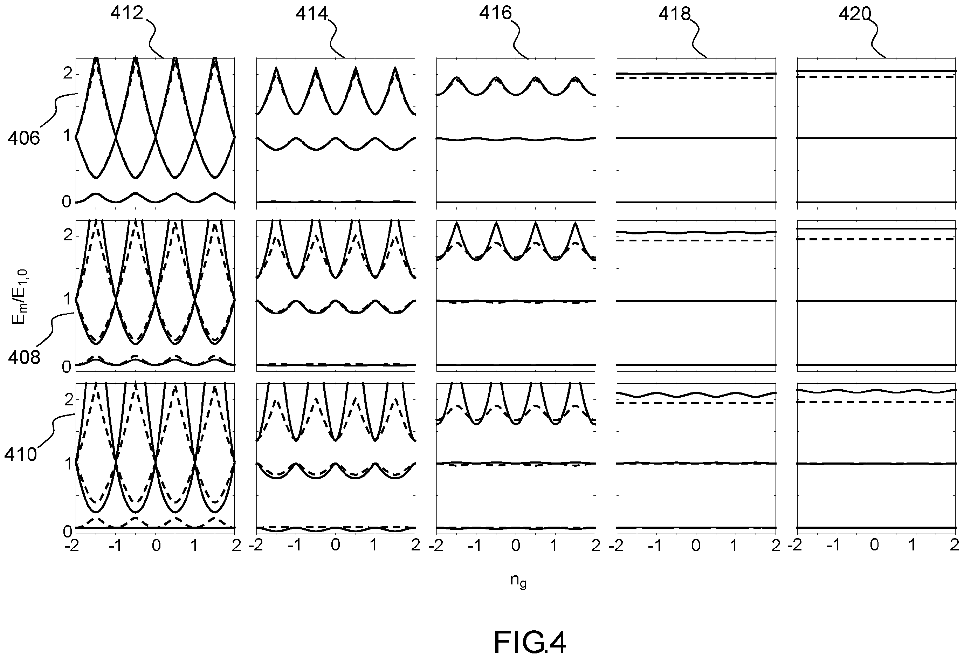

Figs. 4-9 illustrate the effects of the non-linear behavior of both regimes, incipient ferroelectricity and ferroelectricity, on the energy levels $E_m$ of the superconducting qubit. The results presented in Figs. 4-9 were obtained with a superconducting qubit as the one shown of Fig. 2. The energy levels $E_m$ of the superconducting qubit are the eigenvalues of the Hamiltonian of Eq. (1). Unevenly and well separated energy levels $E_m$ are indications of anharmonicity, and small variations of the energy levels $E_m$ with charge offset $n_g$ are indications of insensitivity to charge noise.

Fig. 4 illustrates the first energy levels of the superconducting qubit in the regime of incipient ferroelectricity, according to one or more embodiments. The horizontal axis indicates the offset charge $n_g$ and the vertical axis indicates the normalized energy levels $E_m/E_{1,0}$. The parameter $E_{1,0}$ denotes the energy difference between the ground-state and first level $E_{1,0} = E_1 - E_0$ evaluated at $n_g = 0$. Each panel of Fig. 4 shows the levels $m = 0$, $m = 1$, and $m = 2$, in descending order, *i.e.*, the level at the bottom of the panel is the ground level m = 0. The solid lines and the discontinuous lines correspond to the response of embodiments of the superconducting qubit according to the present description and the Transmon, respectively.

In Fig. 4 row 406 corresponds to the ratio $a/b = 10$, row 408 to the ratio $a/b = 1$, and row 410 to the ratio $a/b = 0.1$. The incipient ferroelectricity response, corresponding to $a > 0$, describes a tendency towards the emergence of spontaneous polarization as $a$ approaches zero, yet the polarization remains zero. On the other hand, the 5 columns of Fig. 4 correspond to different energy ratios $E_J/E_C$. Specifically, column 412 corresponds to $E_J/E_C = 0.25$, column 414 to $E_J/E_C = 1.25$, column 416 to $E_J/E_C = 2.5$, column 418 to $E_J/E_C = 12.5$ and column 420 to $E_J/E_C = 25$.

As seen in row 406 of Fig. 4, when $a/b = 10$ the sensitivity to charge noise (*i.e.*, variations with offset charge) of the capacitor remains significantly supressed and the anharmonicity (separation of energy levels) is visibly enhanced when the ratio $E_J/E_C$ is large. For the case $a/b = 10$, the responses of the superconducting qubit and the Transmon are similar.

As the capacitor is driven towards the transition point (*i.e.*, the point where $a$ changes sign), the ratio $a/b$ decreases, $a/b < 10$, and the overall anharmonicity of the superconducting qubit is substantially improved, as shown in rows 408 and 410 of Fig. 4. This is apparent at column 414 when $E_J/E_C = 1.25$. The enhancement is particularly remarkable at the charge-degeneracy point $n_g = 1/2$, where the charge dispersion of the first two levels has zero slope. Furthermore, the enhancement of the anharmonicity (the uneven separation of the energy levels) of the superconducting qubit relative to the anharmonicity of the Transmon remains as the ratio $E_J/E_C$ increases.

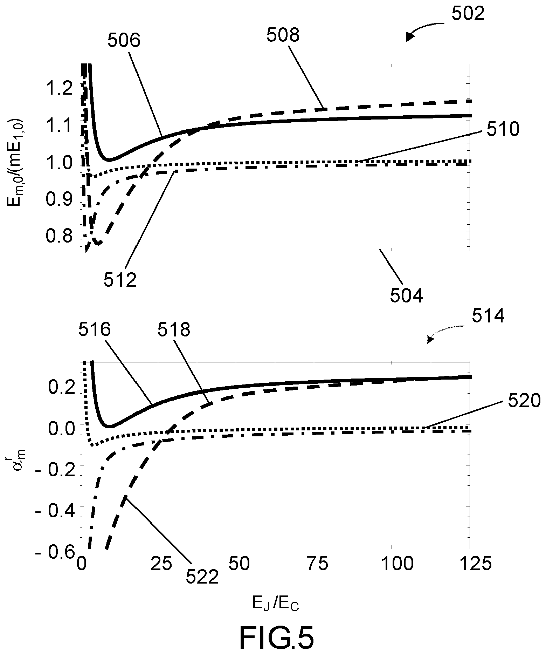

Fig. 5 illustrates parameters used to quantify the spacing of the energy levels of the superconducting qubit, in accordance with one or more embodiments. The spacing of the energy levels in the incipient ferroelectricity response can be quantified by the relation $E_{m,0}/(mE_{1,0})$ where $E_{m,0}$ is the energy level difference $E_{m,0} = E_m - E_0$ evaluated at the offset charge $n_g = 1/2$. Panel 502 in Fig. 5 illustrates the ratio $E_{m,0}/(mE_{1,0})$ for the particular case $a = 0$. In all panels of Fig. 5 the horizontal axis indicates the energy ratio $E_J/E_C$. Plot 506 corresponds to the second energy level, $m = 2$, and plot 508 to the third energy level, $m = 3$ of the superconducting qubit. On the other hand, plots 510 and 512 correspond respectively to energy levels $m = 2$ and $m = 3$ of the Transmon. It can be observed that the spacing between adjacent energy levels increases more rapidly for the superconducting qubit than for the Transmon in the operational regimes of interest.

Specifically, for $E_J \gg E_C$ and $|a|/b \leq 5$, the spacing of energy levels for the superconducting qubit scales as $b^{1/3}E_J^{2/3}$, while for the Transmon it scales as $(E_C E_J)^{1/2}$. Also for $E_J \gg E_C$, the energy gap between adjacent energy levels is approximately uniform in the Transmon while it is not uniform for the superconducting qubit.

Panel 514 in Fig. 5 shows a comparison of the relative anharmonicity of the superconducting qubit in incipient ferroelectricity and the relative anharmonicity of the Transmon. The relative anharmonicity $\alpha_m^r$ is defined as follows:

$$\alpha_m^r = \frac{E_{m,m-1} - E_{1,0}}{E_{1,0}} \qquad\qquad \text{Eq. (5)}$$

where $E_{m,m-1}$ is the energy difference between the ($m$-1)-th and $m$-th levels. Plots 516 and 518 in panel 514 correspond respectively to the energy levels $m = 2$ and $m = 3$ of the superconducting qubit, and plots 520 and 522 correspond respectively to energy levels m = 2 and m = 3 of the Transmon. As seen in panel 514 for large energy ratios, $E_J/E_C \gg 1$, the relative anharmonicity $\alpha_m^r$ of the superconducting qubit (plots 516 and 518) keeps increasing monotonically with $E_J/E_C$, while for the Transmon the relative anharmonicity $\alpha_m^r$ saturates as $E_J/E_C$ becomes larger than 25.

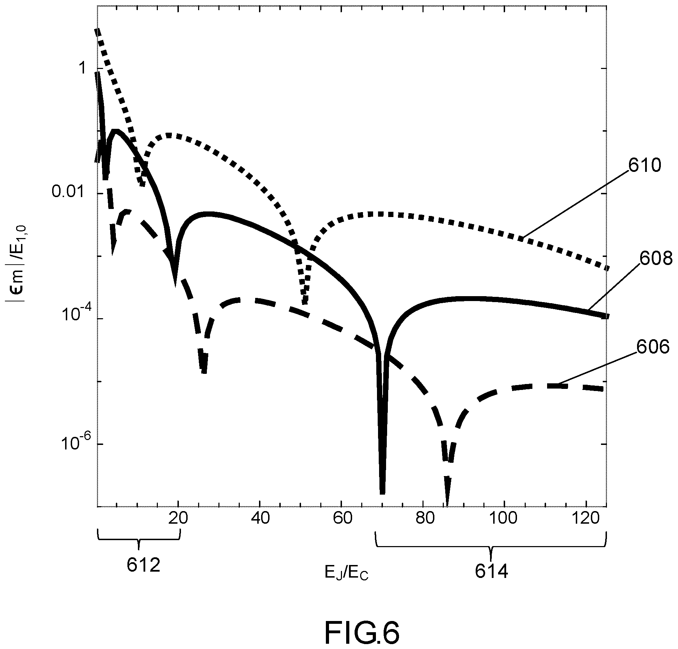

Fig. 6 illustrates the normalized dispersion factor $|\varepsilon_m|/E_{1,0}$ as a function of the energy ratio $E_J/E_C$ for the case $a = 0$, for the superconducting qubit, in accordance with one or more embodiments. The normalized dispersion factor, indicated by the vertical axis of Fig. 6, is given by:

$$\frac{|\epsilon_m|}{E_{1,0}} = \frac{E_m(n_g = 1/2) - E_m(n_g = 0)}{E_{1,0}} \qquad\qquad \text{Eq. (6)}$$

The horizontal axis indicates the energy ratio $E_J/E_C$. The numerator in Eq. (4) quantifies the peak-to-peak energy difference of the m-th level. The dispersion factor allows quantification of the sensitivity of the superconducting qubit to charge noise. Plots 606, 608, and 610 correspond respectively to levels $m = 0$, $m = 1$, and $m = 2$. As seen in Fig. 6, the normalized dispersion factor $|\varepsilon_m|/E_{1,0}$ displays a decaying behaviour with an m-dependent pseudo-periodicity in $E_J/E_C$. For small values of $E_J/E_C$ 612 the normalized dispersion factor decays exponentially, while for large values of $E_J/E_C$ 614 the dispersion becomes negligible. Therefore, the superconducting qubit may be operated for large values of $E_J/E_C$ to achieve high anharmonicity, without exhibiting reduction of insensitivity to charge noise.

The high anharmonicity and high insensitivity to charge noise exhibited in the incipient ferroelectricity response, are not only maintained, but enhanced, in the ferroelectricity regime, due to the nonlinearity of the $Q$ - $V$ relation combined with the spontaneous electric polarization.

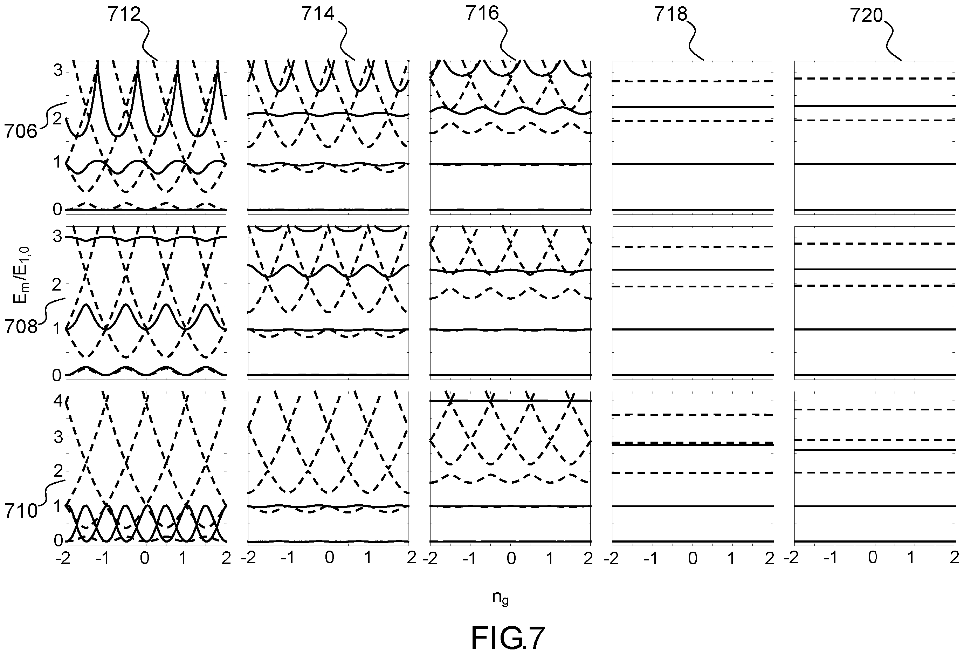

Fig. 7 illustrates the first energy levels of the superconducting qubit in the regime of ferroelectricity, according to one or more embodiments. The horizontal axis indicates the offset charge $n_g$ and the vertical axis indicates the normalized energy levels $E_m/E_{1,0}$. Each panel of Fig. 7 shows the levels $m = 0$, $m = 1$, and $m = 2$, in descending order, i.e., the level at the bottom of the panel is the ground level $m = 0$. The solid lines and the discontinuous lines correspond to the response of embodiments of the superconducting qubit according to the present description and the Transmon, respectively. In Fig. 7 row 706 corresponds to the ratio $a/b = -0.5$, row 708 to the ratio $a/b = -1$, and row 710 to the ratio $a/b = -5$. On the other hand, the 5 columns of Fig. 7 correspond to different energy ratios $E_J/E_C$. Specifically, column 712 corresponds to $E_J/E_C = 0.25$, column 714 to $E_J/E_C = 1.25$, column 716 to $E_J/E_C = 2.5$, column 718 to $E_J/E_C = 12.5$ and column 720 to $E_J/E_C = 25$.

Fig. 7 illustrates that in the regime of ferroelectricity the plots of the energy levels take the form of flat bands as the ratio $E_J/E_C$ increases, as it can be clearly observed in columns 718 and 720. This means that the superconducting qubit becomes insensitive to charge noise for large values of the energy ratio $E_J/E_C$. Notably, this highly desirable insensitivity to charge noise of the superconducting qubit in the ferroelectricity regime is achieved without any loss of anharmonicity. The anharmonicity in the ferroelectricity regime is particularly apparent in columns 712 and 714 ($E_J/E_C = 0.25$ and $E_J/E_C = 1.25$) and row 710 ($a/b = -5$) where the third energy level $m = 2$ is largely separated from the first two energy levels that it does not even appear in the figures. In this case the capacitor is driven deep into the ferroelectricity regime ($|a|/b > 1$), and a two-level system may be obtained.

Thus, the ferroelectricity regime is similar to the incipient ferroelectricity regime and the Transmon regime in the sense that the sensitivity to charge noise is reduced when the energy ratio $E_J/E_C$ increases. However, even when the capacitor is not deep into ferroelectricity regime (i.e., for small values of $|a|/b$), the regime of ferroelectricity provides the most optimal combination of charge-noise insensitivity and anharmonicity. For example, for small values of $|a|/b$ (row 706) and moderate values of $E_J/E_C$ (columns 714 and 716) the anharmonicity is significant not only at the degeneracy point $n_g = 1/2$ but also at the point with no external charge offset, $n_g = 0$.

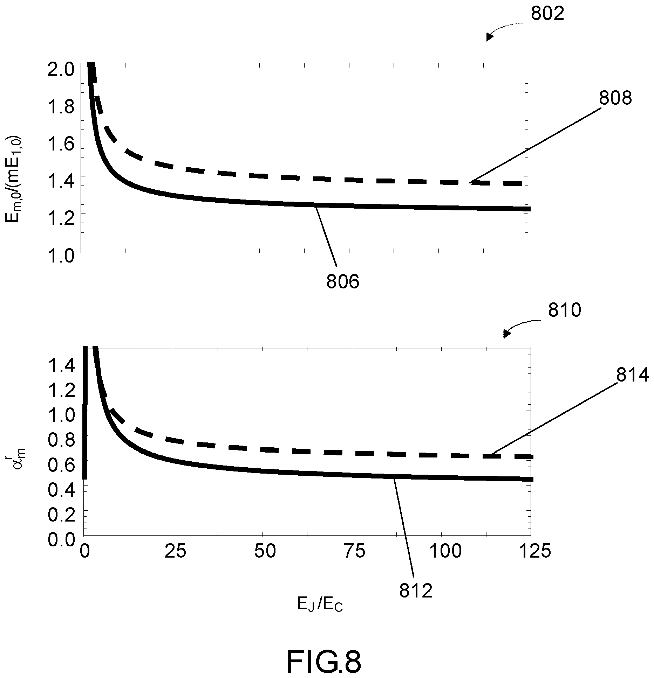

Fig. 8 illustrates parameters that quantify the anharmonicity of the superconducting qubit in the ferroelectricity regime, in accordance with one or more embodiments. Panel 802 of Fig. 8 illustrates the ratio $E_{m0}/(mE_{1,0})$ for the particular case $a/b = -5$. In all panels of Fig. 8 the horizontal axis indicates the energy ratio $E_J/E_C$. Plot 806 corresponds to the second energy level, m = 2, and plot 808 to the third energy level, m = 3. Comparing the ratio $E_{m,0}/(mE_{1,0})$ of panel 802 of the superconducting qubit in ferroelectricity regime with the ratio $E_{m,0}/(mE_{1,0})$ of panel 502 in incipient ferroelectricity, it can be observed that in the ferroelectricity regime the ratio $E_{m,0}/(mE_{1,0})$ also approaches an asymptotic limit as $E_J/E_C$ takes large values. However, in the ferroelectricity 306 regime the asymptotic behavior approaches the asymptotic limit from above the asymptotic limit.

Panel 810 in Fig. 8 shows the relative anharmonicity of the superconducting qubit in the ferroelectricity 306 regime. Plots 812 and 814 in panel 810 correspond respectively to the energy levels $m = 2$ and $m = 3$. Similar to the ratio $E_{m,0}/(mE_{1,0})$ of panel 802, for large energy ratios $E_J/E_C$ the relative anharmonicity $\alpha_m^r$ of panel 810 approaches an asymptotic limit from above the asymptotic limit. Thus, as illustrated by Fig. 8, the anharmonicity of the superconducting qubit in the ferroelectricity response remains strong for large energy ratios $E_J/E_C$.

In one or more embodiments, the superconducting qubit is operated with an energy ratio $E_J/E_C \gtrsim 2.5$. As shown in columns 416-420 of Fig. 4 and column 416-720 of Fig. 7, the charge dispersion becomes negligible (the energy levels have the form of flat bands) for both, the incipient ferroelectricity 304 and the ferroelectricity 306 regimes when $E_J/E_C \gtrsim 2.5$. Furthermore, once the charge dispersion is negligible the anharmonicity is maintained as shown by parameters $E_{m,0}/(mE_{1,0})$ and $\alpha_m^r$ in Figs. 5 and 8.

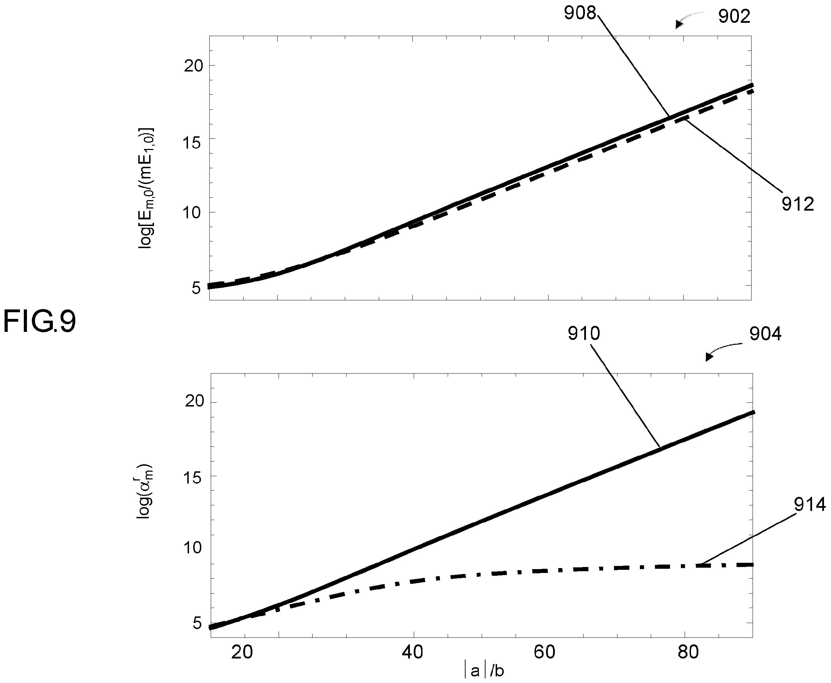

Fig. 9 shows parameters that quantify the anharmonicity of the superconducting qubit as the ratio $|a|/b$ increases. Panel 902 in Fig. 9 shows the variation of $\log[E_{m,0}/(mE_{1,0})]$ and panel 904 shows the variation of $\log(\alpha_m^r)$. In both panels the horizontal axis indicates the ratio $|a|/b$ for $E_J/E_C = 20$. Plots 908 and 910 correspond to the energy level $m = 2$, and plots 912 and 914 correspond to the energy level $m = 3$.

It can be observed in both panels, 902 and 904, that the horizontal axis shows values $|a|/b \gg 1$, corresponding to a superconducting qubit operating in the deep regime of ferroelectricity. As seen in Fig. 9, the logarithm of both anharmonicity parameters $E_{m,0}/(mE_{1,0})$ and $\alpha_m^r$ increase with $|a|/b$, and thus, both anharmonicity parameters $E_{m,0}/(mE_{1,0})$ and $\alpha_m^r$ grow exponentially with $|a|/b$. Thus, the anharmonicity is further strengthened if the superconducting qubit operates in the deep regime of ferroelectricity, corresponding to $|a|/b \gg 1$.

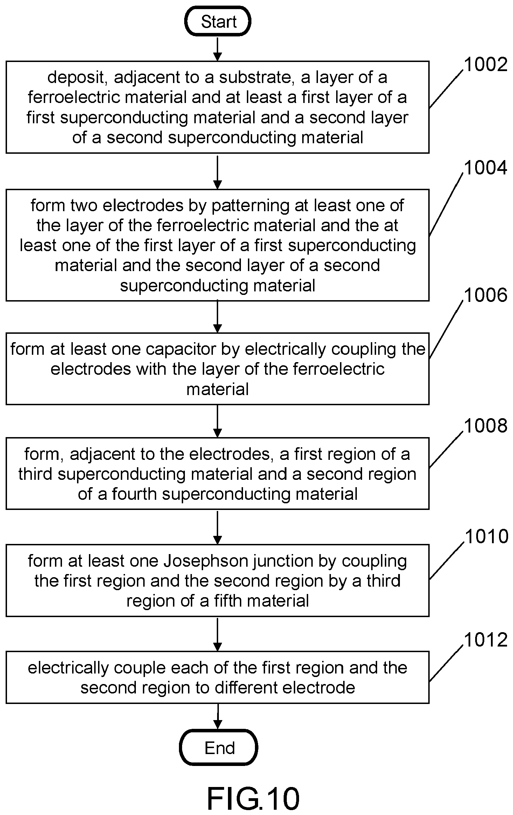

Fig. 10 shows a flowchart in accordance with one or more embodiments. Specifically, Fig. 10 describes a general method to manufacture a superconducting qubit. While the various blocks in Fig. 10 are presented and described sequentially, one of ordinary skill in the art will appreciate that some or all of the blocks may be executed in different orders, may be combined or omitted, and some or all of the blocks may be executed in parallel. Furthermore, the blocks may be performed actively or passively.

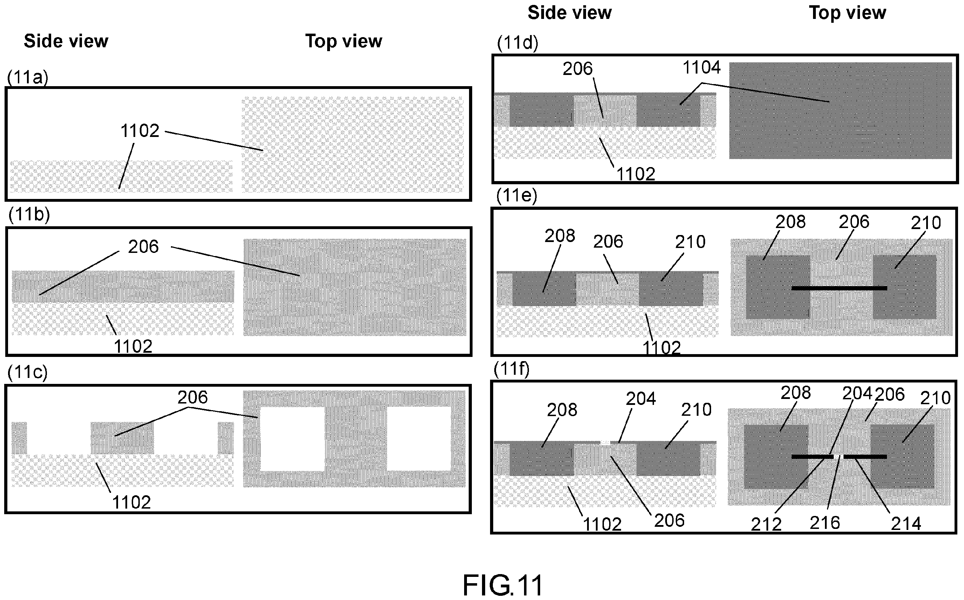

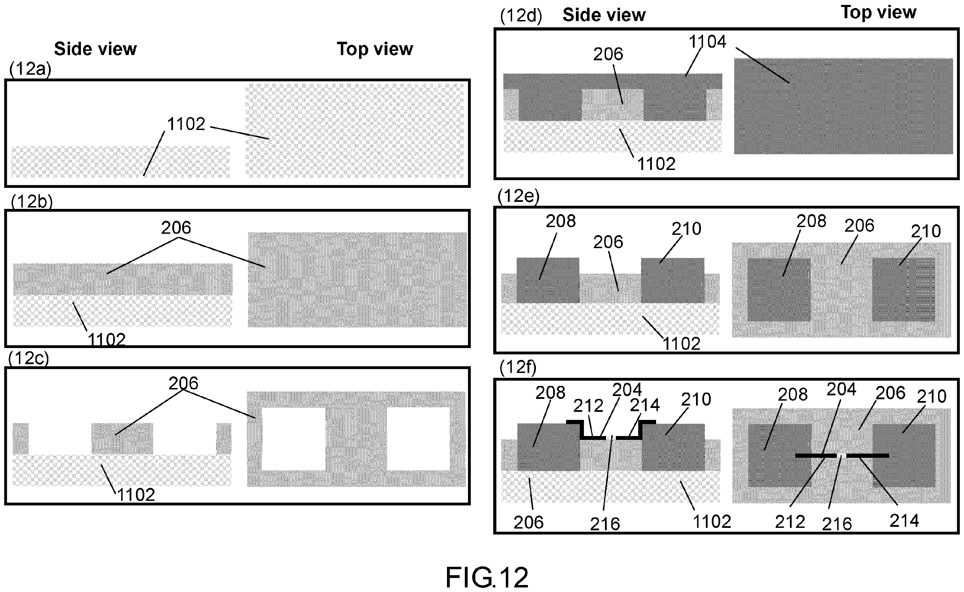

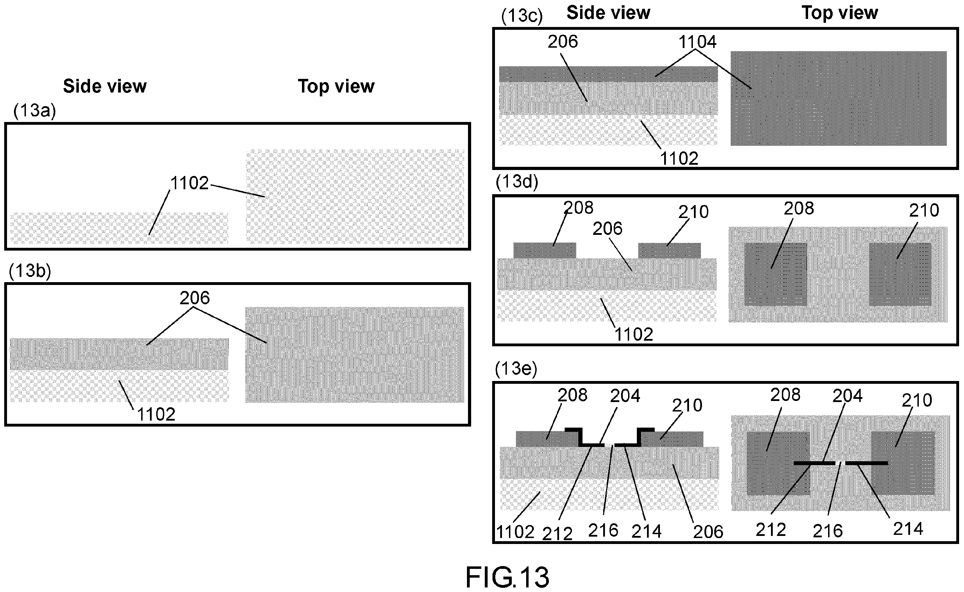

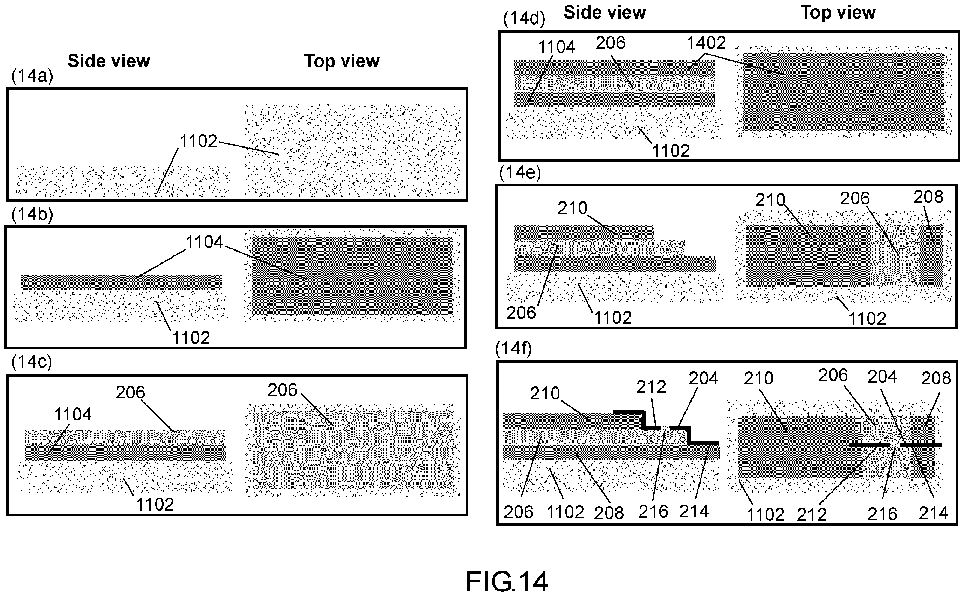

Figs. 11-14 show different non-limiting examples of the manufacturing method of a superconducting qubit according to the present description, for example a superconducting qubit as shown in Fig. 2. Specifically, Fig. 11 is an example of manufacturing the superconducting qubit with electrodes embedded in the first ferroelectric material, and the Josephson junction made with the same superconducting material of the electrodes. Fig. 12 is another example, where the superconducting qubit is manufactured with electrodes embedded in the first ferroelectric material, and the Josephson junction is formed separately from the electrodes. Fig. 13 is an example of manufacturing the superconducting qubit with electrodes not embedded in the first ferroelectric material, and the Josephson junction is formed separately from the electrodes. Fig. 14 is an example where the superconducting qubit is manufactured with the first ferroelectric material between the two electrodes, and the Josephson junction is formed separately from the electrodes.

In block 1002 of Fig. 10 a layer of a first ferroelectric material 206 is deposited adjacent to a substrate 1102 and at least one of a first layer of a first superconducting material 1104 and a second layer of a second superconducting material 1402. The substrate 1102 may be provided in the form of a layer as illustrated in panels 11a, 12a, 13a and 14a. The substrate 1102 may include outgassed C-plane sapphire. The substrate may include other materials, for example, silicon (Si) or aluminium oxide ($Al_2O_3$). The first layer of the first superconducting material 1104 and the second layer of the second superconducting material 1402 may be deposited by molecular beam epitaxy. In some embodiments, the layer of the first ferroelectric material 206 may be the first layer to be deposited, as shown in panels 11b and 11d of Fig. 11, panels 12b and 12d in Fig. 12, and panels 13b and 13c of Fig. 13. In other embodiments, the first layer of the first superconducting material 1104 may be deposited before the layer of the first ferroelectric material 206, and the second layer of the second superconducting material 1406 may be deposited after the layer of the first ferroelectric material 206, as illustrated in panels 14b-4d of Fig. 14. In a non-limiting example, the layer of the first ferroelectric material 206 may be deposited between two layers of the first superconducting material 1104, as shown in panel 14d.

In block 1004 of Fig. 10, two electrodes 208, 210 are formed by patterning at least one of the layer of the first ferroelectric material 206 and the at least one of the first layer of a first superconducting material 1104 and the second layer of a second superconducting material 1402. In some embodiments the layer of the first ferroelectric material 206 may be the first layer to be patterned as shown in panels 11c and 11e in Fig. 11, and panels 12c and 12e in Fig. 12. In other embodiments, only the layer of the first superconducting material 1104 may be patterned to form the electrodes 208, 210, as illustrated in panel 13d of Fig. 13. Alternatively, in some embodiments, the layer of the first ferroelectric material 206 and the at least one of the first layer of a first superconducting material 1104 and the second layer of a second superconducting material 1402 may be patterned simultaneously, as shown in panel 14e in Fig. 14.

In Block 1006 of Fig 10, at least one capacitor is formed by electrically coupling the electrodes 208, 210 with the layer of the first ferroelectric material 206.

In Block 1008, a first region 212 of a third superconducting material and a second region 214 of a fourth superconducting material are formed, adjacent to the electrodes 208, 210. In some embodiments the first region 212 and the second region 214 may be formed by patterning the at least one of the first layer of a first superconducting material 1104 and the second layer of a second superconducting material 1402, as illustrated in panel 11f in Fig. 11. Patterning may be performed, for example, by contact lithography, or by electron-beam lithography. In other embodiments, the first region 212 and the second region 214 may be formed by depositing the third superconducting material and the fourth superconducting material to be adjacent to the electrodes, as illustrated in panel 12f in Fig. 12, panel 13e in Fig. 13, and in panel 14f of Fig. 14. The third and fourth superconducting materials may be deposited, for example, by double angle evaporation.

In Block 1010 of Fig 10, at least one Josephson junction 204 is formed by coupling the first region 212 and the second region 214 by a third region 216 of a fifth material. In some embodiments the fifth material of the third region 216 may be superconducting. As a non-limiting example, the fifth material may be a superconducting material with a critical temperature that is different from critical temperatures of the third and fourth superconducting materials. For example, for niobium nitride NbN, the critical temperatures is 17 K.

In Block 1012 of Fig. 10 each of the first region 212 and the second region 214 are electrically coupled to different electrode 208, 210.

Although described by way of a number of detailed example embodiments, the methods and apparatuses according to the present description comprise various variants, modifications and improvements that will be obvious to those skilled in the art, it being understood that these various variants, modifications and improvements fall within the scope of the invention such as defined by the following claims.

REFERENCES

**Ref. 1**: G. Wendin "Quantum Information Processing with Superconducting Circuits: a Review ". Rep. Prog. Phys. 80, 106001 (2017). arXiv:1610.02208v2

**Ref. 2** : J. Bergou et al. "Quantum Information Processing", Springer. (2021).

**Ref. 3 :** W.C: Smith et al. "Inductively-Shunted Transmon Qubit for Superconducting Circuits". US Patent Number 11,223,355 B2 (2022).

**Ref. 4:** F. Yan et al. "The flux qubit revisited to enhance coherence and reproducibility". Nature Communications, 7:12964, (2016). DOI: 10.1038/ncomms12964

**Ref. 5**: E. Sawaguchi et al. "Dielectric constant of strontium titanate at low temperatures", J. Phys. Soc. Japan, 17, 1666-1667 (1962).

**Ref. 6**: J. G. Bednorz et al., "Sr1-x CaxTiO3: An XY Quantum Ferroelectric with Transition to Randomness" Phys. Rev. Lett. 52, 2289 (1984).

**Claims**

1. A superconducting qubit (200) comprising:

   at least one capacitor (202) comprising a first ferroelectric material (206), a first electrode (208) of a first superconducting material, and a second electrode (210) of a second superconducting material, wherein the first electrode (208) and the second electrode (210) are in electric contact with the first ferroelectric material (206); and
   at least one Josephson junction (204) electrically coupled in parallel to the capacitor (202) wherein said Josephson junction (204) comprises a first region (212) of a third superconducting material and a second region (214) of a fourth superconducting material coupled to said first region (212) by a third region (216) of a fifth material.

2. The superconducting qubit (200) according to claim 1, wherein the fifth material of the third region (216) is a superconducting material with a critical temperature that is different from critical temperatures of the third and fourth superconducting materials.

3. The superconducting qubit (200) according to claim 1, wherein the fifth material of the third region (216) is a second ferroelectric material.

4. The superconducting qubit (200) according to any of the preceding claims, wherein the first superconducting material is NbN.

5. The superconducting qubit (200) according to any of the preceding claims, wherein the superconducting qubit (200) is configured to operate in the regime of incipient ferroelectricity.

6. The superconducting qubit (200) according to any of claims 1 to 4, wherein the superconducting qubit (200) is configured to operate in the regime of ferroelectricity.

7. The superconducting qubit (200) according to any of the preceding claims, wherein the first ferroelectric material is strontium titanate doped with calcium $Sr_{1-x}Ca_xTiO_3$, wherein x is 0, 1, or a value between 0 and 1.

8. The superconducting qubit (200) according to any of the preceding claims, wherein under operation the total energy comprises a quadratic term function of a normalized charge $\hat{n}$ and a non-quadratic term function of the normalized charge $\hat{n}$, and wherein an absolute value of a ratio between a coefficient of the quadratic term and a coefficient of the non-quadratic term is less than or equal to 10.

9. The superconducting qubit (200) according to any of the preceding claims, wherein under operation a charging energy ($E_C$) of the superconducting qubit is less than or equal to an energy ($E_J$) of the Josephson junction (204).

10. A method of manufacturing a superconducting qubit, comprising:

   depositing, adjacent to a substrate (1102), a layer of a first ferroelectric material (206), and at least one of a first layer of a first superconducting material (1104) and a second layer of a second superconducting material (1402);
   forming two electrodes (208, 210) by patterning at least one of the layer of the first ferroelectric material (206) and the at least one of the first layer of a first superconducting material (1104) and the second layer of a second superconducting material (1402);
   forming at least one capacitor (202) by electrically coupling the electrodes (208, 210) with the layer of the first ferroelectric material (206);
   forming, adjacent to the electrodes (208, 210), a first region (212) of a third superconducting material and a second region (214) of a fourth superconducting material;
   forming at least one Josephson junction (204) by coupling the first region (212) and the second region (214) by a third region (216) of a fifth material; and
   electrically coupling each of the first region (212) and the second region (214) to different electrode (208, 210).

11. The method according to claim 10, wherein forming the first region (212) and the second region (214) comprises patterning the layer of the first superconducting material (1104).

12. The method according to claim 10 or claim 11, wherein forming the two electrodes (208, 210) comprises patterning using contact lithography.

13. The method according to any of claims 10 to 12, wherein forming the first region (212) and the second region (214) comprises depositing said first region (212) and second region (214) by double angle evaporation.

14. The method according to any of claims 10 to 13, wherein forming the first region (212) and the second region (214) comprises patterning using electron-beam lithography.

15. The method according to any of claims 10 to 14, wherein the layer of the first ferroelectric material (206) is deposited between two layers of the first superconducting material (1104).

FIG.1(prior art)

EP 4 486 100 A1

FIG.2

FIG.3

EP 4 486 100 A1

FIG.4

FIG.5

FIG.6

FIG.7

EP 4 486 100 A1

FIG.8

FIG.9

EP 4 486 100 A1

```
                          ┌─────────┐
                          │  Start  │
                          └────┬────┘
                               │
                               ▼
          ┌──────────────────────────────────────────┐   ╱1002
          │  deposit, adjacent to a substrate, a layer of a │ ╱
          │  ferroelectric material and at least a first layer of a │
          │  first superconducting material and a second layer │
          │  of a second superconducting material     │
          └──────────────────┬───────────────────────┘
                             │
                             ▼
          ┌──────────────────────────────────────────┐   ╱1004
          │  form two electrodes by patterning at least one of │ ╱
          │  the layer of the ferroelectric material and the at │
          │  least one of the first layer of a first superconducting │
          │  material and the second layer of a second │
          │  superconducting material                 │
          └──────────────────┬───────────────────────┘
                             │
                             ▼
          ┌──────────────────────────────────────────┐   ╱1006
          │  form at least one capacitor by electrically coupling the │ ╱
          │  electrodes with the layer of the ferroelectric │
          │  material                                 │
          └──────────────────┬───────────────────────┘
                             │
                             ▼
          ┌──────────────────────────────────────────┐   ╱1008
          │  form, adjacent to the electrodes, a first region of a │ ╱
          │  third superconducting material and a second region │
          │  of a fourth superconducting material     │
          └──────────────────┬───────────────────────┘
                             │
                             ▼
          ┌──────────────────────────────────────────┐   ╱1010
          │  form at least one Josephson junction by coupling │ ╱
          │  the first region and the second region by a third │
          │  region of a fifth material               │
          └──────────────────┬───────────────────────┘
                             │
                             ▼
          ┌──────────────────────────────────────────┐   ╱1012
          │  electrically couple each of the first region and the │ ╱
          │  second region to different electrode      │
          └──────────────────┬───────────────────────┘
                             │
                             ▼
                        ┌─────────┐
                        │   End   │
                        └─────────┘
```

# FIG.10

**Side view**

**Top view**

**Side view**

**Top view**

(11a)

1102

(11d)

206    1104

1102

(11b)

206

1102

(11e)

208    206    210

208    206    210

1102

(11c)

206

1102

(11f)

208    204    210

208  204 206   210

1102    206

212    216    214

**FIG.11**

EP 4 486 100 A1

**FIG.12**

FIG.13

FIG.14

Europäisches
Patentamt

European
Patent Office

Office européen
des brevets

**EUROPEAN SEARCH REPORT**

Application Number

EP 23 30 6069

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/015299 A1 (WARE MATTHEW ELLIOTT [US] ET AL) 19 January 2023 (2023-01-19) * paragraph [0040] – paragraph [0045] * * paragraph [0048]; figure 6 * * paragraph [0026] * ----- | 1-15 | INV. H10N60/01 G06N10/40 H10N60/12 H10N69/00 |
| Y | CN 115 172 588 A (UNIV XIANGTAN) 11 October 2022 (2022-10-11) * paragraph [0003] – paragraph [0023] * ----- | 1-15 | |
| Y | JP H06 334231 A (SHARP KK) 2 December 1994 (1994-12-02) * paragraph [0001] – paragraph [0013] * ----- | 3 | |

TECHNICAL FIELDS
SEARCHED      (IPC)

H10N
G06N

The present search report has been drawn up for all claims

| Place of search | Date of completion of the search | Examiner |
|---|---|---|
| Munich | 8 December 2023 | Gröger, Andreas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..............................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 30 6069

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2023

| Patent document cited in search report | | Publication date | Patent family member(s) | | Publication date |
|---|---|---|---|---|---|
| US 2023015299 | A1 | 19-01-2023 | AU | 2022239291 A1 | 15-06-2023 |
| | | | US | 2023015299 A1 | 19-01-2023 |
| | | | WO | 2022197482 A1 | 22-09-2022 |
| CN 115172588 | A | 11-10-2022 | NONE | | |
| JP H06334231 | A | 02-12-1994 | NONE | | |

For more details about this annex : see Official Journal of the European Patent Office, No. 12/82

## REFERENCES CITED IN THE DESCRIPTION

**Patent documents cited in the description**

- US 11223355 B2, W.C: Smith

**Non-patent literature cited in the description**

- **G. WENDIN**. Quantum Information Processing with Superconducting Circuits: a Review. *Rep. Prog. Phys*, 2017, vol. 80, 106001
- **J. BERGOU et al.** Quantum Information Processing. Springer, 2021
- **F. YAN et al.** The flux qubit revisited to enhance coherence and reproducibility. *Nature Communications*, 2016, vol. 7, 12964
- **E. SAWAGUCHI et al.** Dielectric constant of strontium titanate at low temperatures. *J. Phys. Soc. Japan*, 1962, vol. 17, 1666-1667
- **J. G. BEDNORZ et al.** Sr1-x CaxTiO3: An XY Quantum Ferroelectric with Transition to Randomness. *Phys. Rev. Lett.*, 1984, vol. 52, 2289